# EUROPÄISCHE PATENTSCHRIFT

(11) **EP 2 281 139 B1**
(45) Veröffentlichungstag und Bekanntmachung des Hinweises auf die Patenterteilung: **09.11.2011**
(21) Anmeldenummer: 09733144.1
(22) Anmeldetag: 14.04.2009
(51) Int. Cl.: F17C 3/08, G01R 33/035

(54) **KRYOSTAT UND BIOMAGNETISCHES MESSSYSTEM MIT HOCHFREQUENZABSCHIRMUNG**
CRYOSTAT AND BIOMAGNETIC MEASURING SYSTEM HAVING A HIGH-FREQUENCY SHIELDING
CRYOSTAT ET SYSTÈME DE MESURE BIOMAGNÉTIQUE AVEC BLINDAGE POUR HAUTES FRÉQUENCES

(30) Priorität: 16.04.2008 DE 102008019091
(43) Veröffentlichungstag der Anmeldung: 09.02.2011
(73) Patentinhaber: BMDSYS PRODUCTION GMBH, 07745 Jena (DE)
(72) Erfinder: ERNÈ, Sergio, Nicola, 89233 Neu-Ulm (DE); NOWAK, Hannes, 07751 Jena (DE)
(74) Vertreter: Stößel, Matthias
(86) Internationale Anmeldenummer: PCT/EP2009/002718
(87) Internationale Veröffentlichungsnummer: WO 2009/127390

(56) Entgegenhaltungen:
- EP-A1- 0 200 080
- EP-A1- 0 401 420
- EP-A1- 0 503 108
- EP-A2- 0 584 866
- WO-A1-90/13770
- DE-A1- 4 104 232
- DE-A1- 19 525 514
- DE-A1- 19 546 670

## Beschreibung

### Gebiet der Erfindung

Die Erfindung betrifft einen Kryostaten, welcher insbesondere für den Einsatz in einem biomagnetischen Messsystem geeignet ist, sowie ein biomagnetisches Messsystem, welches einen derartigen Kryostaten umfasst. Die Erfindung betrifft weiterhin ein Verfahren zur Herstellung eines Kryostaten, welcher insbesondere für biomagnetische Messungen geeignet ist. Derartige Kryostaten, Messsysteme und Verfahren können insbesondere im Bereich der Kardiologie oder auch in anderen medizinischen Bereichen, wie beispielsweise der Neurologie, eingesetzt werden. Auch andere Anwendungen, beispielsweise nichtmedizinische Anwendungen, beispielsweise Anwendungen in der Materialforschung und Werkstoffuntersuchung, sind denkbar.

### Stand der Technik

In den vergangenen Jahren haben magnetische Messsysteme, welche bis dahin im Wesentlichen der Grundlagenforschung vorbehalten waren, Einzug in viele Bereiche der biologischen und medizinischen Wissenschaften gehalten. Insbesondere die Neurologie und die Kardiologie profitieren von derartigen biomagnetischen Messsystemen.

Grundlage der biomagnetischen Messsysteme ist die Tatsache, dass die meisten Zellaktivitäten im menschlichen oder tierischen Körper mit elektrischen Signalen, insbesondere elektrischen Strömen, verbunden sind. Die Messung dieser elektrischen Signale selbst, welche durch die Zellaktivität hervorgerufen werden, ist beispielsweise aus dem Bereich der Elektrokardiographie bekannt. Neben den rein elektrischen Signalen sind die elektrischen Ströme jedoch auch mit einem entsprechenden Magnetfeld verbunden, deren Messung sich die verschiedenen bekannten biomagnetischen Messmethoden zunutze machen.

Während die elektrischen Signale bzw. deren Messung außerhalb des Körpers von verschiedenen Faktoren abhängen, wie beispielsweise den unterschiedlichen elektrischen Leitfähigkeiten der Gewebetypen zwischen der Quelle und der Körperoberfläche, durchdringen magnetische Signale nahezu ungestört diese Gewebebereiche. Die Messung dieser Magnetfelder und deren Änderungen erlaubt somit Rückschlüsse auf die innerhalb des Gewebes fließenden Ströme, zum Beispiel elektrische Ströme innerhalb des Herzmuskels. Eine Messung dieser magnetischen Felder mit hoher Zeit- und/oder Ortsauflösung über einen gewissen Bereich hinweg erlaubt somit bildgebende Verfahren, welche beispielsweise eine aktuelle Situation verschiedener Bereiche eines menschlichen Herzens wiedergeben können. Andere bekannte Anwendungen liegen beispielsweise im Bereich der Neurologie.

Die Messung von Magnetfeldern biologischer Proben oder Patienten, bzw. die Messung von zeitlichen Änderungen dieser Magnetfelder, stellt jedoch messtechnisch eine hohe Herausforderung dar. So sind beispielsweise die Magnetfeldänderungen im menschlichen Körper, welche bei der Magnetokardiographie zu messen sind, ungefähr eine Million Mal schwächer als das magnetische Feld der Erde. Die Detektion dieser Änderungen erfordert also extrem sensitive Magnetsensoren. In den meisten Fällen werden daher im Bereich der biomagnetischen Messungen supraleitende Quanten-Interferenz-Messgeräte (Superconducting Quantum Interference Devices, SQUIDs) eingesetzt. Derartige Sensoren müssen in der Regel, um den supraleitenden Zustand zu erreichen bzw. aufrechtzuerhalten, typischerweise auf 4 °K (-269 °C) gekühlt werden, wozu üblicherweise flüssiges Helium verwendet wird. Die SQUIDs sind daher in der Regel einzeln oder in einem SQUID-Array in einem sog. Dewar-Gefäß angeordnet und werden dort entsprechend gekühlt. Alternativ werden zurzeit Laser-gepumpte magneto-optische Sensoren entwickelt, die annähernd vergleichbare Empfindlichkeit aufweisen können. Auch in diesem Fall werden die Sensoren in der Regel in einer Array-Anordnung in einem Behälter zur Temperaturstabilisierung angeordnet.

Derartige Behälter zur Temperaturstabilisierung, insbesondere Behälter für die Kühlung von Magnetsensoren und so genannte Dewar-Gefäße, werden im Folgenden allgemein als "Kryostat" bezeichnet. Insbesondere kann es sich hierbei um Helium-Kryostate oder andere Arten von Kryostaten handeln. Zwischen dem Kryostaten und dem Kryostatgefäß, welches auch als Dewar bezeichnet wird, wird dabei im Folgenden nicht unterschieden, auch wenn der eigentliche Kryostat neben dem Kryostatgefäß weitere Teile umfassen kann.

Die Herstellung des Kryostaten für die Aufnahme biomagnetischer Sensorsysteme stellt konstruktiv eine große Herausforderung dar. Die Sensoren werden üblicherweise in einer vorgegebenen Anordnung in diesen Kryostaten eingebracht, beispielsweise in Form einer hexagonalen Anordnung von SQUIDs oder anderen Magnetsensoren. Dabei umfasst üblicherweise der Kryostat ein inneres Gefäß, mit darin aufgenommenen Sensoren, sowie ein äußeres Gefäß. Der Zwischenraum zwischen innerem Gefäß und äußerem Gefäß wird evakuiert. Dabei ist es jedoch von erheblicher Bedeutung, dass der Abstand zwischen den im inneren Kryostatgefäß aufgenommenen Sensoren und der Hautoberfläche des Patienten so klein wie möglich gehalten wird, da beispielsweise die Signalstärke mit einer hohen Potenz des Abstandes zwischen Sensor und Hautoberfläche abnimmt. Dementsprechend muss der Abstand zwischen den Böden des inneren und äußeren Gefäßes klein und äußerst konstant gehalten werden.

Aus dem Stand der Technik sind zahlreiche Kryostate bekannt, welche für magnetische Messungen eingesetzt werden können. So wird beispielsweise in W. Andrä and H. Nowak: Magnetism in Medicine, 2nd Edition, Wiley-VCH Verlag, Weinheim, 2007, S. 116-117 ein Kryostat beschrieben, der für biomagnetische Messungen auf der Basis supraleitender Magnetsensoren eingesetzt werden kann. Andere Beispiele von Kryostaten sind beispielsweise aus US 4,827,217 oder WO98/06972 A1 bekannt.

Aus EP 401 420 A1 ist eine HF-Abschirmvorrichtung in einem Dewar-Gefäß außerhalb dessen Innenraums bekannt, welche als allseitig HF-dichte Umhüllung um die supraleitenden Teile einer Messeinrichtung ausgebildet ist. Auch eine HF-Abschirmung des Querschnitts des Dewar-Halses ist vorgesehen. Die HF-Abschirmvorrichtung dient zugleich als thermischer Strahlungsschild, wobei ihre die supraleitenden Teile umgebenden Flächen auf einem Zwischentemperaturniveau gehalten sind. Darüber hinaus sind zur Unterdrückung von Wirbelströmen die Flächen der HF-Abschirmvorrichtung zumindest im Bereich der supraleitenden Teile in einzelne elektrisch leitende, untereinander isolierte Leiterbahnen aufgeteilt.

Eine besondere Herausforderung bei Kryostaten, welche in biomagnetischen Messsystemen eingesetzt werden sollen, besteht darin, dass die für die eigentliche biomagnetische Messung eingesetzten Sensoren eine vergleichsweise hohe Bandbreite für die Aufnahme magnetischer oder elektromagnetischer Signale aufweisen. So sind beispielsweise die supraleitenden SQUIDs für Signale vom niederfrequenten Bereich von ca. 0,01 Hz bis hin in den Mikrowellenbereich, also den Gigahertz- bis Terahertz-Bereich, empfindlich. Die eigentlichen Messsignale liegen jedoch im niederfrequenten Bereich zwischen typischerweise 0,01 Hz und 2000 Hz. Insbesondere eine üblicherweise für die Ansteuerung und Auswertung der Sensoren erforderliche Elektronik oder auch andere Störquellen produzieren jedoch Störstrahlung, welche bei den Messsignalen zu erheblicher Beeinträchtigung der Signalqualität führen können. Erforderlich ist daher eine lokale Abschirmung der Sensoren gegen Hochfrequenzeinstrahlung bis hin in den Mikrowellenbereich. Die Herausforderung dieser Strahlungsabschirmung ist bei den bislang bekannten Kryostaten, wie beispielsweise dem in der oben beschriebenen Veröffentlichung von W. Andrä und H. Nowak beschriebenen Kryostaten, welcher über Strahlungsschirme verfügt, nur teilweise befriedigend gelöst und bietet Raum für weitere Verbesserungen.

### Aufgabe der Erfindung

Die Aufgabe der vorliegenden Erfindung besteht somit darin, einen Kryostaten bereitzustellen, welcher die oben beschriebenen Nachteile bekannter Kryostate zumindest weitgehend vermeidet. Insbesondere soll der Kryostat einerseits eine hohe Signalqualität biomagnetischer Messungen gewährleisten und andererseits für die Aufnahme von Sensoren für die biomagnetischen Messungen geeignet sein.

### Beschreibung der Erfindung

Diese Aufgabe wird gelöst durch einen Kryostaten, ein biomagnetisches Messsystem und ein Verfahren zur Herstellung eines Kryostaten mit den Merkmalen der unabhängigen Ansprüche. Vorteilhafte Weiterbildungen der Erfindung, welche einzeln oder in Kombination verwirklicht werden können, sind in den Unteransprüchen dargestellt.

Es wird ein Kryostat für den Einsatz in einem biomagnetischen Messsystem vorgeschlagen, also ein Vakuum-isolierter Container im Sinne der obigen Beschreibung, welcher für die Aufnahme mindestens eines biomagnetischen Sensors, insbesondere mindestens eines SQUIDs oder mindestens eines SQUID-Arrays, geeignet ist. Der vorgeschlagene Kryostat umfasst mindestens ein Innengefäß, beispielsweise ein Innengefäß, welches mit flüssigem Helium befüllbar ist, sowie ein das Innengefäß zumindest teilweise umgebendes Außengefäß. Dabei ist das Innengefäß derart relativ zum Außengefäß angeordnet, dass sich zwischen Innen- und Außengefäß zumindest in Teilbereichen mindestens ein Hohlraum ausbildet. Der Hohlraum ist derart ausgestaltet, beispielsweise durch eine entsprechende Dichtigkeit der Zusammenfügung von Innen- und Außengefäß, dass dieser evakuierbar ist, also mit einem Unterdruck beaufschlagbar ist. Zu diesem Zweck kann der Kryostat beispielsweise zusätzlich mindestens ein Vakuumventil, also ein Ventil, welches mit einer Vakuumpumpe von außerhalb des Kryostaten verbindbar ist, versehen sein.

In dem Hohlraum ist mindestens ein Strahlungsschirm zur zumindest teilweisen Abschirmung des Kryostaten bzw. des mindestens einen im Inneren des Kryostaten aufnehmbaren biomagnetischen Sensors gegenüber elektromagnetischer Strahlung aufgenommen. Der Strahlungsschirm kann beispielsweise ganz oder teilweise als metallischer Strahlungsschirm, also als Strahlungsschirm mit mindestens einem metallischen Werkstoff, ausgestaltet sein.

Eine Grundidee der vorliegenden Erfindung besteht darin, die Strahlungsabschirmung gegenüber elektromagnetischer Strahlung, insbesondere im Hochfrequenzbereich, dadurch zu verbessern, dass eine Möglichkeit zur Erdung des mindestens einen Strahlungsschirms geschaffen wird. Bei üblichen, herkömmlichen Kryostaten, in welchen teilweise bereits metallische Strahlungsschirme vorhanden sind, wie beispielsweise dem in der oben beschriebenen Veröffentlichung von W. Andrä und H. Nowak beschriebenen Kryostaten, sind teilweise bereits derartige Strahlungsschirme offenbart. Diese Strahlungsschirme werden jedoch weder geerdet, noch ist überhaupt eine Möglichkeit zur Erdung dieser Strahlungsschirme vorgesehen. Es hat sich jedoch gezeigt, dass eine Erdung, das heißt eine Verbindung des Strahlungsschirms mit einer elektrischen Erde und/oder einer elektrischen Masse, zu einer erheblichen Verbesserung der Abschirmung und somit der Signalqualität führen kann.

Dementsprechend wird vorgeschlagen, den Kryostaten mit mindestens einer zumindest teilweise in dem Hohlraum angeordneten Erdleitung auszustatten. Diese Erdleitung dient der Verbindung des Strahlungsschirms mit einer elektrischen Masse und/oder Erde. Zu diesem Zweck ist die Erdleitung in dem Hohlraum mit dem Strahlungsschirm verbunden. Der Kryostat weist seinerseits mindestens eine elektrische Durchführung, insbesondere mindestens eine elektrische Durchführung in dem mindestens einen Außengefäß, auf, mittels derer die Erdleitung von einer Außenseite des Kryostaten her elektrisch kontaktierbar und erdbar ist.

Auf diese Weise bietet der vorgeschlagene Kryostat gegenüber aus dem Stand der Technik bekannten Kryostaten erhebliche Vorteile hinsichtlich der Hochfrequenzabschirmung. Die "Erdung" der Abschirmung ist nicht auf das Volumen und gegebenenfalls die metallische Masse der Strahlungsschirme innerhalb des Kryostaten selbst beschränkt, welche aus bautechnischen Gründen begrenzt sein können, sondern es kann eine externe, beliebig optimierbare und hinsichtlich ihrer Güte nicht durch das Kryostatvolumen beschränkte elektrische Masse bzw. elektrische Erde verwendet werden.

Elektrische Durchführungen, insbesondere durch vakuumdichte Außengefäße, weisen hinsichtlich ihrer Anforderungen an die Vakuumdichtigkeit technische Herausforderungen auf, welche durch vergleichsweise hohen bautechnischen Aufwand gelöst werden müssen. In diesem Zusammenhang ist es erfindungsgemäß besonders bevorzugt, wenn die elektrische Durchführung zumindest teilweise mindestens ein Vakuumventil umfasst. Derartige Vakuumventile sind in der Regel ohnehin bei den genannten Kryostaten vorhanden, da mit Hilfe dieser Ventile beispielsweise der Hohlraum zwischen dem Innengefäß und dem Außengefäß evakuiert werden kann. Der Begriff des Vakuumventils ist dabei weit zu fassen und kann grundsätzlich, alternativ oder zusätzlich zu einem Ventil im eigentlichen Sinne, beispielsweise eine beliebige Öffnung, beispielsweise einen Stutzen, umfassen, mittels derer der Hohlraum mit einem Vakuum beaufschlagbar ist. Insofern sind beispielsweise Ventile, Vakuumstutzen, Vakuumverschlüsse oder ähnliche Vorrichtungen umfasst. So kann das Vakuumventil beispielsweise auf der Außenseite des Kryostaten mit einem entsprechenden Stutzen oder Anschluss versehen sein, um eine Vakuumpumpe an dieses Vakuumventil anzuschließen. Nach der Evakuierung kann dieses Vakuumventil beispielsweise verschlossen werden, so dass das Vakuumventil beispielsweise einen Vakuumverschluss aufweisen kann. Alternativ oder zusätzlich kann das Vakuumventil auch ein Sicherheitsventil umfassen, beispielsweise um eine Implosion des Kryostaten zu vermeiden. Auch andere Ausgestaltungen sind möglich.

Erfindungsgemäß wird also vorgeschlagen, in einer besonders bevorzugten Ausführungsform das mindestens eine Vakuumventil ganz oder teilweise bauteilidentisch mit der elektrischen Durchführung auszugestalten. Eine zusätzliche elektrische Durchführung ist damit nicht mehr erforderlich. Besonders einfach realisierbar ist diese Ausführungsform der Erfindung, wenn das Vakuumventil mindestens einen zumindest teilweise metallischen Bestandteil aufweist und dieser metallische Bestandteil, welcher vorzugsweise das Außengefäß vollständig durchdringt, kann dann als Bestandteil der Erdleitung verwendet werden. Beispielsweise kann die Erdleitung einen ersten, flexiblen Leiter umfassen, welcher den mindestens einen Strahlungsschirm mit dem metallischen Bestandteil des Vakuumventils verbindet, wobei das Vakuumventil bzw. dessen metallischer Bestandteil selbst dann einen zweiten Teil der Erdleitung bildet. Weitere Teile der Erdleitung können vorgesehen sein. Der metallische Bestandteil kann beispielsweise ein Gehäuse des Vakuumventils, einen metallischen Stutzen des Vakuumventils oder ein ähnliches metallisches Bauteil umfassen, vorzugsweise ein metallisches Bauteil, welches das Außengefäß ohnehin ganz oder vorzugsweise vollständig durchdringt.

Auf diese Weise kann erfindungsgemäß die Möglichkeit einer Erdung und einer Ableitung des Potentials des Strahlungsschirms von der Außenseite des Kryostatgefäßes her besonders leicht realisierbar sein. Da die Vakuumventile üblicherweise bereits eine hohe Vakuumdichtigkeit aufweisen, kann auf zusätzliche, abdichtende Maßnahmen verzichtet werden. Eine Kontaktierung der Durchführung von außen her kann dann beispielsweise wiederum mittels flexibler Leiter, einer Schraubverbindung, einer Klemmverbindung oder anderen Arten elektrischer Verbindungen erfolgen, um die elektrische Durchführung auf der Außenseite des Kryostaten mit der Masse bzw. Erde zu verbinden.

Weitere bevorzugte Ausführungsformen betreffen die Ausgestaltung des Strahlungsschirms. So ist es besonders bevorzugt, wenn der Strahlungsschirm ein Schichtaufbau mit mindestens zwei übereinander liegenden metallischen Schichten umfasst. Diese metallischen Schichten sollen vorzugsweise untereinander elektrisch durch eine ohmsche Verbindung und/oder eine kapazitive Verbindung verbunden sein. Auch die Verbindung des mindestens einen Strahlungsschirms zur Erdleitung kann durch eine ohmsche und/oder kapazitive Verbindung erfolgen.

Der Strahlungsschirm soll vorzugsweise eingerichtet sein, um als Ganzes eine Abschirmung elektromagnetischer Strahlung um mindestens 5 dB in einem Frequenzbereich zwischen 100 kHz und einem GHz zu bewirken.

Diese Abschirmung ist beispielsweise dadurch zu gewährleisten, dass der Strahlungsschirm eine oder mehrere Metallfolien und/oder Gewebe (beispielsweise metallische Gewebe) und/oder aus geklebten Drähten hergestellte Folien (coil foils) umfasst. Diese Metallfolien können beispielsweise eine Aluminiumfolie, eine Kupferfolie, eine Silberfolie, eine Goldfolie oder eine Folie mit einer beliebigen Kombination dieser Materialien umfassen. Besonders bewährt haben sich im praktischen Einsatz Aluminiumfolien, beispielsweise Aluminiumfolien in Form von selbstklebenden Aluminiumklebebändern. Beispielsweise lassen sich Aluminiumklebebänder mit einer Breite von 50 mm und einer Aluminiumdicke von 70 µm einsetzen. Allgemein können die Metallfoliendicken zwischen 5 µm und 500 µm, insbesondere zwischen 10 µm und 100 µm, aufweisen, wobei die angegebenen Dicken von 70 µm bevorzugt sind. Insgesamt können die Metallfolien selbstklebende Metallfolien umfassen.

Wie auch in der oben beschriebenen Veröffentlichung von W. Andrä und H. Nowak, ist es besonders bevorzugt, wenn in dem mindestens einen Hohlraum mindestens eine Superisolationsschicht zur Abschirmung von Wärmestrahlung angeordnet ist. Diese mindestens eine Superisolationsschicht weist ein Material mit möglichst geringer thermischer Leitfähigkeit auf, beispielsweise ein nicht-metallisches Material, beispielsweise ein Kunststoffmaterial. Die Superisolationsschicht kann insbesondere als Superisolationsfolie ausgestaltet sein, beispielsweise als Superisolationsfolie mit einer Dicke im Bereich zwischen 10 µm und 1 mm, beispielsweise mit einer Dicke von ca. 100 µm. Besonders bevorzugt ist die Verwendung von Kunststofffolien, beispielsweise Polyethylenfolien, zum Beispiel Mylar-Folien.

Die Superisolationsschicht kann zusätzlich zumindest einseitig mindestens eine metallische Beschichtung umfassen. Diese zumindest einseitige metallische Beschichtung, welche beispielsweise auf eine Polyethylenfolie der Superisolationsschicht aufgebracht sein kann, kann beispielsweise eine Aluminiumschicht und/oder eine Schicht der anderen der oben genannten Metalle umfassen. Beispielsweise kann eine Beschichtung im Bereich von 500 nm mit zu 50 µm, vorzugsweise im Bereich zwischen 8 µm und 10 µm, aufgebracht werden. Im Gegensatz zum eigentlichen Strahlungsschirm ist es jedoch besonders bevorzugt, wenn diese mindestens eine metallische Beschichtung nicht mit der Erdleitung elektrisch in Verbindung steht, was jedoch gleichwohl dennoch der Fall sein kann.

In dem Hohlraum können insbesondere alternierend mehrere Superisolationsschichten und mehrere Strahlungsschirme angeordnet sein. Beispielsweise können, zum Beispiel mittels eines Wickelverfahrens, abwechselnd aluminiumbeschichtete Polyethylenfolien als Superisolationsschichten und selbstklebende Aluminiumklebebänder in den Hohlraum eingebracht werden, wobei die Aluminiumklebebänder mit der Erdleitung verbunden werden. Auf diese Weise lässt sich besonders effizient sowohl eine gute thermische Abschirmung durch die nicht-geerdeten Superisolationsschichten als auch eine Hochfrequenzabschirmung durch die Schichten der Strahlungsschirme bewerkstelligen. Beispielsweise können jeweils drei Schichten der Superisolationsschichten und der Strahlungsschirme übereinander geschichtet, beispielsweise übereinander gewickelt, sein. Auch jeweils eine Schicht, jeweils zwei Schichten oder eine größere Anzahl von Schichten sind jedoch denkbar.

Neben dem Kryostaten in einer oder mehreren der oben beschriebenen Ausführungsformen wird weiterhin ein biomagnetisches Messsystem vorgeschlagen, welches mindestens einen Kryostaten nach einer oder mehreren der oben beschriebenen Ausführungsformen umfasst. Weiterhin umfasst das biomagnetische Messsystem mindestens einen biomagnetischen Sensor zur Detektion eines oder mehrerer magnetischer Felder. Beispielsweise kann dieser biomagnetische Sensor mindestens einen supraleitenden Quanten-Interferenzdetektor (SQUID) und/oder ein Array derartiger SQUIDs, umfassen. Alternativ oder zusätzliche können auch andere Arten von Magnetsensoren eingesetzt werden, beispielsweise magnetooptische Sensoren. Der mindestens eine biomagnetische Sensor ist vorzugsweise in dem mindestens einen Innengefäß aufgenommen, beispielsweise in einer oder mehreren Vertiefungen an der Unterseite des Innengefäßes, so dass beispielsweise der mindestens eine Sensor unmittelbar mit dem Kühlmedium, beispielsweise dem flüssigen Helium, in Verbindung stehen kann.

Neben dem Kryostaten und dem Sensor kann das biomagnetische Messsystem darüber hinaus eine Vielzahl weiterer Komponenten umfassen Beispielsweise kann das biomagnetische Messsystem eine Ansteuer- und Auswerteelektronik umfassen, welche außerhalb und/oder ganz oder teilweise innerhalb des Kryostaten angeordnet sein kann. Bei einer Anordnung außerhalb des Kryostaten können beispielsweise im Deckelbereich des Kryostaten elektrische Durchführungen vorgesehen sein, um den mindestens einen Sensor anzusteuern bzw. elektronisch auszulesen. Derartige Ansteuer- und Auswerteschaltungen, insbesondere für SQUIDs, sind dem Fachmann aus anderen biomagnetischen Messsystemen gemäß dem Stand der Technik bekannt. Daneben kann das biomagnetische Messsystem weitere Komponenten umfassen, beispielsweise Auswertesysteme, Messcontainer, Patientenliegen oder ähnliches.

Besonders bevorzugt ist es dabei, wenn die Erdleitung des Kryostaten mit mindestens einer elektrischen Masse der Erde verbunden ist. Zu diesem Zweck kann beispielsweise die mindestens eine elektrische Durchführung mit einer Laborerde oder einer elektrischen Erde eines Messplatzes im Krankenhaus oder einer ähnlichen Diagnoseeinrichtung verbunden sein.

Neben dem Kryostaten und dem biomagnetischen Messsystem wird weiterhin ein Verfahren zur Herstellung eines Kryostaten für den Einsatz in einem biomagnetischen Messsystem vorgeschlagen. Das Verfahren kann insbesondere zur Herstellung des Kryostaten gemäß einer oder mehrerer der oben beschriebenen Ausführungsformen genutzt werden, so dass bezüglich möglicher Ausgestaltungen des Kryostaten, welche entsprechende Herstellungsschritte implizieren, auf die obige Beschreibung verwiesen werden kann. Der Kryostat weist wiederum ein Innengefäß, ein Außengefäß und mindestens einen Hohlraum zwischen dem Innengefäß und dem Außengefäß auf. Die nachfolgend beschriebenen Verfahrensschritte können in der dargestellten Reihenfolge durchgeführt werden, können jedoch auch in einer anderen als der dargestellten Reihenfolge ausgeführt werden. So können beispielsweise auch einzelne oder mehrere der genannten Verfahrensschritte wiederholt oder zeitlich parallel oder zeitlich überlappend durchgeführt werden. Weiterhin können auch zusätzliche, nicht aufgeführte Verfahrensschritte durchgeführt werden.

In einem Verfahrensschritt wird zunächst das Innengefäß des Kryostaten erzeugt. Weiterhin wird mindestens ein Strahlungsschirm zur Abschirmung des Kryostaten gegenüber elektromagnetischer Strahlung erzeugt, wobei der Strahlungsschirm vorzugsweise das Innengefäß zumindest teilweise umgibt. Dies kann, wie oben beschrieben, beispielsweise mittels einer Wickeltechnik realisiert werden, beispielsweise mittels einer Wickeltechnik, bei welcher der mindestens eine Strahlungsschirm direkt oder indirekt auf das mindestens eine Innengefäß aufgewickelt wird.

In einem weiteren Verfahrensschritt wird das Außengefäß des Kryostaten erzeugt und mit dem Innengefäß derart montiert, dass zwischen dem Innengefäß und dem Außengefäß mindestens ein evakuierbarerer Hohlraum angeordnet ist. Das Innengefäß und das Außengefäß können beispielsweise ganz oder teilweise aus Kunststoff, beispielsweise verstärktem Kunststoff hergestellt sein. So kann beispielsweise ein glasfaserverstärkter Kunststoff, beispielsweise ein Epoxid, verwendet werden. Beispielsweise lassen sich Kunststoffe, zum Beispiel glasfaserverstärkte Kunststoffe, mit einer Wandstärke von ca. 1 mm als Grundkörper für das Innengefäß einsetzen. Auch mehrere derartiger Grundkörper können ineinander geschachtelt werden. Beispielsweise lassen sich zwei, drei oder mehr Kunststoff-Zylinder, beispielsweise glasfaserverstärkte Kunststoff-Zylinder, ineinander schachteln, um das Innengefäß zu erzeugen. Das Außengefäß kann in einer ähnlichen Herstellungsweise hergestellt werden. Zur Montage des Innengefäßes und Außengefäßes und zur Erzeugung des evakuierbaren Hohlraums können entsprechende Klebetechniken eingesetzt werden, wobei jedoch auch andere Montagetechniken einsetzbar sind. Die Montage erfolgt dabei derart, dass der Strahlungsschirm zumindest teilweise in dem Hohlraum aufgenommen ist. Die Montage erfolgt weiterhin derart, dass das Außengefäß mindestens eine elektrische Durchführung umfasst, wobei der Strahlungsschirm mit der Durchführung über mindestens eine Erdleitung elektrisch verbunden ist. Zur Erzeugung des Strahlungsschirms kann beispielsweise eine Wickeltechnik verwendet werden, wobei der Strahlungsschirm beispielsweise ganz oder teilweise auf das Innengefäß aufgewickelt werden kann. Zusätzlich können, wie oben beschrieben, auch eine oder mehrere Superisolationsschichten verwendet werden, welche beispielsweise alternierend zu den Strahlungsschirmen aufgewickelt oder auf sonstige Weise in den Kryostaten eingebracht werden können.

### Ausführungsbeispiele

Weitere Einzelheiten und Merkmale der Erfindung ergeben sich aus der nachfolgenden Beschreibung eines bevorzugten Ausführungsbeispiels in Verbindung mit den Unteransprüchen. Hierbei können die jeweiligen Merkmale für sich alleine oder zu mehreren in Kombination miteinander verwirklicht sein. Die Erfindung ist nicht auf das Ausführungs-beispiel beschränkt. Das Ausführungsbeispiel ist in der Figur schematisch dargestellt.

Im Einzelnen zeigt:

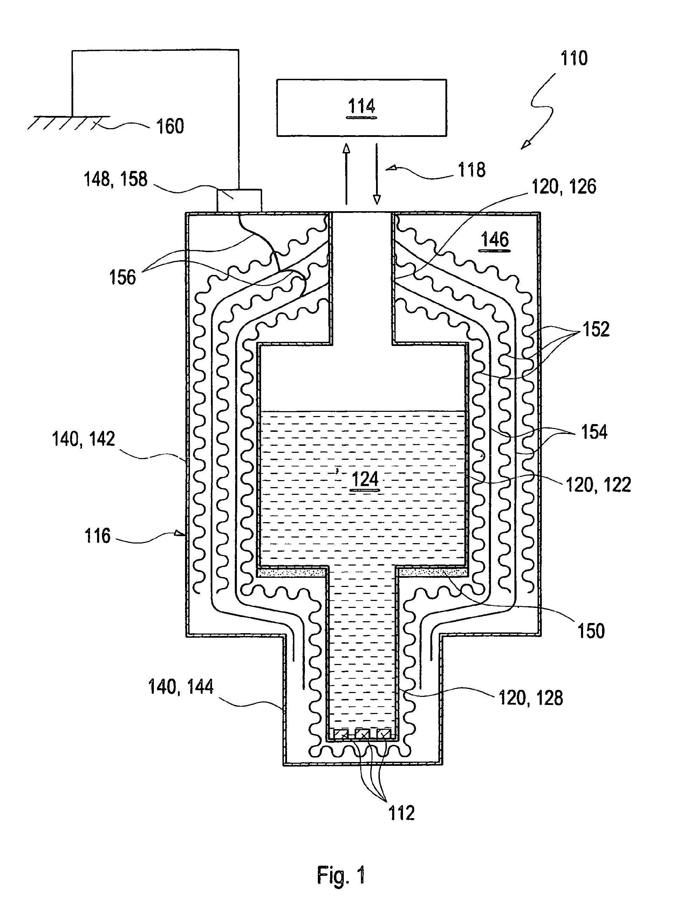

Figur 1 ein Ausführungsbeispiel eines biomagnetischen Messsystems mit einem Kryostaten in einer Schnittdarstellung.

In Figur 1 ist schematisch ein Ausführungsbeispiel eines erfindungsgemäßen biomagnetischen Messsystems 110 in Schnittdarstellung von der Seite gezeigt. Dieses biomagnetische Messsystem 110 umfasst in dem dargestellten Ausführungsbeispiel eine Mehrzahl von Magnetsensoren 112, eine Ansteuer- und Auswerteelektronik 114 sowie einen Kryostaten 116. Die Magnetsensoren 112 können beispielsweise ein Array von SQUIDs umfassen, welche über elektrische Verbindungen 118, die in Figur 1 lediglich symbolisch angedeutet sind, mit der Ansteuer- und Auswerteelektronik 114 verbunden sein können.

Der Kryostat umfasst ein Innengefäß 120, welches beispielsweise im Wesentlichen zylindersymmetrisch ausgestaltet sein kann. Das Innengefäß 120 verfügt beispielsweise über einen Haupttank 122, in welchen beispielsweise flüssiges Helium 124 bei 4,2 K eingebracht sein kann, sowie über ein verengtes Halsrohr 126 an der Oberseite des Haupttanks 122 und einen ebenfalls gegenüber dem Haupttank 122 verengten Finger 128 an der Unterseite des Haupttanks 122. An der Unterseite des Fingers 128 können die Magnetsensoren 112 in den Finger 128 eingebracht sein, beispielsweise in Vertiefungen in der Wand des Innengefäßes 122, so dass der Abstand zwischen den Magnetsensoren 112 und einem unterhalb des Kryostaten 116 in Figur 1 angeordneten (in Figur 1 nicht dargestellten) Patienten möglichst gering ist.

Weiterhin umfasst der Kryostat 116 bei dem Ausführungsbeispiel gemäß Figur 1 ein das Innengefäß 120 zumindest weitgehend umgebendes Außengefäß 140. Das Außengefäß 140 weist dabei wiederum im Wesentlichen eine Zylindersymmetrie auf, mit einem Haupttank 142 und einem dem Finger 128 des Innengefäßes 120 umgebenden Finger 144. Zwischen dem Innengefäß 120 und dem Außengefäß 140 ist ein Hohlraum 146 ausgebildet, welcher evakuierbar ist. Dies bedeutet, dass die Verbindungen zwischen dem Innengefäß 120 und dem Außengefäß 140 derart erfolgen, dass ein Unterdruck, welcher durch Abpumpen einer Atmosphäre aus dem Hohlraum 146 hergestellt werden kann, über einen Zeitraum von mehreren Stunden, vorzugsweise über einen Zeitraum von mehreren Tagen oder Wochen, gehalten werden kann. Zu diesem Zweck weist das Außengefäß 140 des Kryostaten 116 weiterhin mindestens ein Vakuumventil 148 auf, welches beispielsweise in dem dargestellten Ausführungsbeispiel an der Oberseite des Haupttanks 142 des Außengefäßes 140 angeordnet sein kann. Das Vakuumventil 148 kann, alternativ oder zusätzlich zum Evakuieren des Hohlraums 146, auch ein Sicherheitsventil umfassen oder andere Arten von Vakuumventilen 148.

Am Bodenteil des Haupttanks 122 des Innengefäßes 120 kann ein Absorber 150 vorgesehen sein, beispielsweise auf einer den Finger 128 umgebenden Stirnfläche des Haupttanks 142. Als Absorber 150 können beispielsweise Aktivkohle, Zeolith und/oder andere poröse Materialien verwendet werden. Alternativ oder zusätzlich können auch an anderen Orten des Kryostaten 116, insbesondere des Innengefäßes 120, derartige Absorber 150 vorgesehen sein.

Das Außengefäß 140 befindet sich im Einsatz des Kryostaten 116 in etwa auf Raumtemperatur, wohingegen das Innengefäß 120 auf Flüssig-Helium-Temperatur heruntergekühlt ist. Um diesen Temperaturunterschied über einen längeren Zeitraum hinweg aufrechtzuerhalten, sind im Hohlraum 146 Superisolationsschichten 152 angeordnet. In dem dargestellten Ausführungsbeispiel sind, zumindest im Bereich des Haupttanks 122, drei derartige Schichten von Superisolationsschichten 152 vorgesehen. Beispielsweise kann das Innengefäß 120 zylinderförmige Grundkörper aus glasfaserverstärktem Epoxid-Kunststoff mit jeweils einer Wandstärke von 1 mm umfassen. Beispielsweise können drei derartiger glasfaserverstärkter Kunststoffzylinder ineinander geschachtelt werden. Auf diesem Grundkörper des Innengefäßes 120 kann dann die erste Superisolationsschicht 152 aufgewickelt werden, welche beispielsweise eine einseitig mit einer 8 µm dicken Aluminiumschicht beschichtete Polyethylenfolie (Mylar) umfassen kann. Die Superisolationsschichten 152 können das Innengefäß 120 ganz oder teilweise umgeben. In dem dargestellten Ausführungsbeispiel umgibt beispielsweise die innerste Superisolationsschicht 152 das Innengefäß 120 vollständig, also auch den Bereich des Fingers 128 einschließlich der die Magnetsensoren 112 aufnehmenden Stirnfläche dieses Fingers 128, wohingegen die übrigen Schichten der Superisolationsschichten 152 lediglich das Halsrohr 126 und den Haupttank 122 umgeben. Auch andere Ausgestaltungen sind jedoch denkbar, beispielsweise eine andere Anzahl von Superisolationsschichten 152, eine andere Verteilung der Superisolationsschichten oder ähnliches.

Weiterhin sind in dem Hohlraum 146 in dem in Figur 1 dargestellten Ausführungsbeispiel eine Mehrzahl von Strahlungsschirmen 154 vorgesehen, welche eine Einstrahlung von elektromagnetischer Hochfrequenzstrahlung ins Innere des Innengefäßes 120 des Kryostaten 116 zumindest teilweise verhindern sollen. Dabei ist wiederum in dem dargestellten Ausführungsbeispiel lediglich ein Teil des Innengefäßes 120 von diesen Strahlungsschirmen 154 umgeben, beispielsweise das Halsrohr 126 und der Haupttank 122, sowie ein Teil des Fingers 128. Auch eine andere Anordnung ist jedoch wiederum denkbar, beispielsweise eine Anordnung, bei welcher einer oder wenige dieser Strahlungsschirme 154 auch den Finger 128 vollständig umgeben oder einen größeren Abschnitt dieses Fingers 144, so dass die Magnetsensoren 112 in dem Finger 128 weiter abgeschirmt wenden. Vorzugsweise verbleibt jedoch die nach unten weisende Stirnfläche des Fingers 144, über welche die eigentliche Signalaufnahme der Magnetsensoren 112 erfolgt, unbedeckt von den Strahlungsschirmen 154.

Besonders bevorzugt ist es, wenn die Strahlungsschirme 154 ein selbstklebendes Aluminiumband umfassen. Beispielsweise kann ein Aluminiumklebeband verwendet werden, welches eine Breite von 50 mm und eine Dicke von ca. 70 µm aufweist. Die Strahlungsschirme 154 bewirken den eigentlichen Effekt der Strahlungsabschirmung des Kryostaten 116 gegenüber elektromagnetischen Strahlungen, beispielsweise Strahlungen im Bereich zwischen 100 kHz und 1 GHz. In dem dargestellten Ausführungsbeispiel wird dabei ein alternierender Aufbau von Superisolationsschichten 152 und Strahlungsschirmen 154 verwendet. Zu diesem Zweck können in dem Hohlraum 146 alternierend jeweils Schichten der Superisolationsschichten 152 und des Aluminiumklebebandes der Strahlungsschirme 154 auf den Grundkörper des zylindersymmetrischen Innengefäßes 120 aufgewickelt werden. Während die optional vorhandene Metallisierung der Superisolationsschichten 152 in dem dargestellten Ausführungsbeispiel nicht zusätzlich kontaktiert wird, werden die Strahlungsschirme 154 mit einer Erdleitung 156 verbunden. Diese Erdleitung 156 ist in Figur 1 symbolisch dargestellt und kann beispielsweise ein oder mehrere flexible elektrische Verbindungen, Durchkontaktierungen, starre elektrische Verbindungen oder ähnliches umfassen. Die Ankopplung kann über eine ohmsche elektrische Verbindung und/oder eine kapazitive Anbindung erfolgen. Über die Erdleitung 156 sind die Strahlungsschirme 154 oder zumindest ein Teil dieser Strahlungsschirme 154 untereinander elektrisch verbunden. Weiterhin werden die Strahlungsschirme 154 über die Erdleitung 156 mit dem Vakuumventil 148 verbunden, welches gleichzeitig als elektrische Durchführung 158 wirkt. Auf diese Weise kann auf eine zusätzliche elektrische Durchführung 158 verzichtet werden. Zu diesem Zweck ist vorzugsweise das Vakuumventil 148 ganz oder teilweise als metallisches Vakuumventil ausgestaltet. Hierdurch ist es möglich, die Strahlungsschirme 154 außerhalb des Kryostaten 116 zu erden, beispielsweise indem das Vakuumventil 148, beispielsweise das Evakuierungsventil, außerhalb des Kryostaten 116 mit einer Laborerde 160 verbunden wird.

Das in Figur 1 dargestellte Ausführungsbeispiel des Kryostaten 116 und des biomagnetischen Messsystems 110 bewirkt eine einfache und effiziente Abschirmung der Magnetsensoren 112 gegenüber elektromagnetischen Störungen, beispielsweise elektromagnetischen Störungen, welche durch die Ansteuer- und Auswerteelektronik 114 des biomagnetischen Messsystems 110 selbst verursacht werden. Die ursprünglich vorhandene Abschirmung durch die Superisolationsschichten 152 wird durch die Strahlungsschirme 154 effizient derart erweitert, dass diese als Radiofrequenzschirm wirken. Durch die Zugänglichmachung dieser Strahlungsschirme 154 über das Vakuumventil 148 kann eine zuverlässige Erdung und dadurch eine Verbesserung der Signalqualität sichergestellt werden.

Auch die Herstellung des in Figur 1 gezeigten Schichtaufbaus kann einfach erfolgen, insbesondere unter Verwendung der oben beschriebenen Wickeltechnik. Dabei kann die Wicklung beispielsweise lose erfolgen, indem mit mechanischem Spiel die einzelnen Schichten auf das Innengefäß 120 aufgewickelt werden. Auf diese Weise kann auch eine Kontaktierung der Folienpakete der Strahlungsschirme 154 untereinander problemlos erfolgen. Dieser gewickelte Schichtaufbau kann dann in das Außengefäß 140 eingesetzt werden, wonach beispielsweise eine Deckelplatte des Außengefäßes 140 aufgesetzt werden kann, um eine Vakuumdichtigkeit des Hohlraums 146 zu gewährleisten. Auf diese Weise lässt sich der in Figur 1 dargestellte Kryostat 116 kostengünstig und zuverlässig herstellen.

### Bezugszeichenliste

- 110: biomagnetisches Messsystem
- 112: Magnetsensoren
- 114: Ansteuer- und Auswertelektronik
- 116: Kryostat
- 118: elektrische Verbindungen
- 120: Innengefäß
- 122: Haupttank
- 124: flüssiges Helium
- 126: Halsrohr
- 128: Finger
- 140: Außengefäß
- 142: Haupttank des Außengefäßes
- 144: Finger des Außengefäßes
- 146: Hohlraum
- 148: Vakuumventil
- 150: Absorber
- 152: Superisolationsschichten
- 154: Strahlungsschirm
- 156: Erdleitung
- 158: elektrische Durchführung
- 160: Laborerde

## Patentansprüche

1. Kryostat (116) für den Einsatz in einem biomagnetischen Messsystem (110), umfassend mindestens ein Innengerfäß (120) und mindestens ein Außengefäß (140) sowie mindestens einen zwischen dem Innengefäß (120) und dem Außengefäß (140) angeordneten Hohlraum (146), wobei der Hohlraum (146) mit einem Unterdruck beaufschlagbar ist, wobei in dem Hohlraum (146) mindestens ein Strahlungsschirm (154) zur Abschirmung des Kryostaten (116) gegenüber elektromagnetischer Strahlung aufgenommen ist, wobei der Kryostat (116) weiterhin mindestens eine Erdleitung (156) zur Verbindung des Strahlungsschirms (154) mit einer elektrischen Masse oder Erde (160) umfasst, wobei die Erdleitung (156) in dem Hohlraum (146) mit dem Strahlungsschirm (154) verbunden ist und wobei der Kryostat (116) mindestens eine elektrische Durchführung (158) aufweist, mittels derer die Erdleitung (156) durch das Außengefäß (140) von einer Außenseite des Kryostaten (116) elektrisch kontaktierbar ist, wobei die elektrische Durchführung (158) zumindest teilweise mindestens ein Vakuumventil (148) umfasst, wobei das Vakuumventil (148) eingerichtet ist, um eine Evakuierung des Hohlraums (146) zu ermöglichen.

2. Kryostat (116) nach dem vorhergehenden Anspruch, wobei das Vakuumventil (148) zumindest einen zumindest teilweise metallischen Bestandteil aufweist, wobei der metallische Bestandteil als Teil der Erdleitung (156) verwendet wird.

3. Kryostat (116) nach dem vorhergehenden Anspruch, wobei der Strahlungsschirm (154) einen Schichtaufbau mit mindestens zwei übereinander liegenden metallischen Schichten umfasst, wobei die metallischen Schichten untereinander elektrisch durch eine ohmsche Verbindung und/oder durch eine kapazitive Verbindung verbunden sind.

4. Kryostat (116) nach einem der vorhergehenden Ansprüche, wobei der Strahlungsschirm (154) eingerichtet ist, um eine Abschirmung elektromagnetischer Strahlen um mindestens 5 dB in einem Frequenzbereich zwischen 100 kHz und 1 GHz zu bewirken.

5. Kryostat (116) nach einem der vorhergehenden Ansprüche, wobei der Strahlungsschirm (154) mindestens eine der folgenden Metallfolien umfasst: eine Aluminiumfolie; eine Kupferfolie; eine Silberfolie; eine Goldfolie.

6. Kryostat (116) nach einem der vorhergehenden Ansprüche, wobei der Strahlungsschirm (154) mindestens eine Metallfolie mit einer Dicke zwischen 5 Mikrometern und 500 Mikrometern, insbesondere zwischen 10 Mikrometern und 100 Mikrometern und besonders bevorzugt mit einer Dicke von 70 Mikrometern umfasst.

7. Kryostat (116) nach einem der beiden vorhergehenden Ansprüche, wobei die Metallfolic eine selbstklebende Metallfolie umfasst.

8. Kryostat (116) nach einem der vorhergehenden Ansprüche, weiterhin umfassend mindestens eine in dem Hohlraum (146) angeordnete Superisolationsschicht (152) zur Abschirmung von Wärmestrahlung.

9. Kryostat (116) nach dem vorhergehenden Anspruch, wobei die Superisolationsschicht (152) mindestens eine Kunststoffolie umfasst, insbesondere eine Polyethylenfolie.

10. Kryostat (116) nach einem der beiden vorhergehenden Ansprüche, wobei die Superisolationsschicht (152) zusätzlich zumindest einseitig mindestens eine metallische Beschichtung umfasst.

11. Kryostat (116) nach einem der drei vorhergehenden Ansprüche, wobei in dem Hohlraum (146) alternierend mehrere Superisolationsschichten (152) und mehrere Strahlungsschirme (154) angeordnet sind.

12. Biomagnetisches Messsystem (110), umfassend mindestens einen Kryostaten (116) nach einem der vorhergehenden Ansprüche, weiterhin umfassend mindestens einen biomagnetischen Sensor (112) zur Detektion eines magnetischen Feldes.

13. Biomagnetisches Messsystem (110) nach dem vorhergehenden Anspruch, wobei die Erdleitung (156) des Kryostaten (116) mit mindestens einer elektrischen Masse oder Erde (160) verbunden ist.

14. Verfahren zur Herstellung eines Kryostaten (116) für den Einsatz in einem biomagnetischen Messsystem (110), insbesondere eines Kryostaten (116) nach einem der vorhergehenden, auf einen Kryostaten (116) gerichteten Ansprüche, umfassend die folgenden Schritte:
- mindestens ein Innengefäß (120) des Kryostaten (116) wird erzeugt;
- mindestens ein Strahlungsschirm (154) zur Abschirmung des Kryostaten (116) gegenüber elektromagnetischer Strahlung wird erzeugt, wobei der Strahlungsschirm (154) vorzugsweise das Innengefäß (120) zumindest teilweise umgibt;
- mindestens ein Außengefäß (140) des Kryostaten (116) wird erzeugt und mit dem Innengefäß (120) derart montiert, dass zwischen dem Innengefäß (120) und dem Außengefäß (140) mindestens ein evakuierbarer Hohlraum (146) angeordnet ist, wobei der Strahhmgsschirm (154) zumindest teilweise in dem Hohlraum (146) aufgenommen ist, wobei das Außengefäß (140) mindestens eine elektrische Durchführung (158) umfasst, wobei der Strahlungsschirm (154) mit der Durchführung (158) über mindestens eine Erdleitung (156) elektrisch verbunden wird, wobei die elektrische Durchführung (158) zumindest teilweise mindestens ein Vakuumventil (148) umfasst, wobei das Vakuumventil (148) eingerichtet ist, um eine Evakuierung des Hohlraums (146) zu ermöglichen.

15. Verfahren nach dem vorhergehenden Anspruch, wobei zur Erzeugung des Strahlungsschirms (154) eine Wickeltechnik verwendet wird, wobei der Strahlungsschirm (154) auf das Innengefäß (120) aufgewickelt wird.

## Claims

1. Cryostat (116) for use in a biomagnetic measurement system (110), comprising at least one inner vessel (120) and at least one outer vessel (140), and at least one cavity (146) arranged between the inner vessel (120) and the outer vessel (140), wherein negative pressure can be applied to the cavity (146), wherein at least one radiation shield (154) for shielding the cryostat (116) from electromagnetic radiation is housed in the cavity (146), wherein the cryostat (116) furthermore comprises at least one ground lead (156) for connecting the radiation shield (154) to an electrical ground or earth (160), wherein the ground lead (156) is connected to the radiation shield (154) in the cavity (146) and wherein the cryostat (116) has at least one electrical feed-through (158), by means of which the ground lead (156) can be contacted electrically from an outer side of the cryostat (116) through the outer vessel (140), wherein the electrical feed-through (158) at least in part comprises at least one vacuum valve (148), the vacuum valve (148) being designed to allow an evacuation of the cavity (146).

2. Cryostat (116) according to the preceding claim, wherein the vacuum valve (148) has at least one at least partly metallic component, the metallic component being used as part of the ground lead (156).

3. Cryostat (116) as claimed in the preceding claim, wherein the radiation shield (154) comprises a layered design with at least two metallic layers lying above one another, the metallic layers being electrically interconnected by an ohmic connection and/or by a capacitive connection.

4. Cryostat (116) as claimed in one of the preceding claims, wherein the radiation shield (154) is designed to bring about shielding of electromagnetic radiation by at least 5 dB in a frequency range between 100 kHz and 1 GHz.

5. Cryostat (116) as claimed in one of the preceding claims, wherein the radiation shield (154) comprises at least one of the following metal foils: an aluminum foil; a copper foil; a silver foil; a gold foil.

6. Cryostat (116) as claimed in one of the preceding claims, wherein the radiation shield (154) comprises at least one metal foil with a thickness between 5 micrometers and 500 micrometers, more particularly between 10 micrometers and 100 micrometers, and particularly preferably with a thickness of 70 micrometers.

7. Cryostat (116) as claimed in one of the two preceding claims, wherein the metal foil comprises a self-adhesive metal foil.

8. Cryostat (116) as claimed in one of the preceding claims, furthermore comprising at least one superinsulation layer (152), arranged in the cavity (146), for shielding against heat radiation.

9. Cryostat (116) as claimed in the preceding claim, wherein the superinsulation layer (152) comprises at least one plastics foil, more particularly a polyethylene foil.

10. Cryostat (116) as claimed in one of the two preceding claims, wherein the superinsulation layer (152) additionally comprises at least one metallic coating on at least one side.

11. Cryostat (116) as claimed in one of the three preceding claims, wherein a plurality of superinsulation layers (152) and a plurality of radiation shields (154) are arranged alternately in the cavity (146).

12. Biomagnetic measurement system (110), comprising at least one cryostat (116) as claimed in one of the preceding claims, furthermore comprising at least one biomagnetic sensor (112) for detecting a magnetic field.

13. Biomagnetic measurement system (110) as claimed in the preceding claim, wherein the ground lead (156) of the cryostat (116) is connected to at least one electrical ground or earth (160).

14. Method for producing a cryostat (116) for use in a biomagnetic measurement system (110), more particularly a cryostat (116) as claimed in one of the preceding claims directed to a cryostat (116), comprising the following steps:
- at least one inner vessel (120) of the cryostat (116) is produced;
- at least one radiation shield (154) for shielding the cryostat (116) from electromagnetic radiation is produced, wherein the radiation shield (154) preferably surrounds the inner vessel (120) at least in part;
- at least one outer vessel (140) of the cryostat (116) is produced and assembled with the inner vessel (120) such that at least one cavity (146) that can be evacuated is arranged between the inner vessel (120) and the outer vessel (140), wherein the radiation shield (154) is housed at least in part in the cavity (146), wherein the outer vessel (140) comprises at least one electrical feed-through (158), wherein the radiation shield (154) is electrically connected to the feed-through (158) via at least one ground lead (156), wherein the electrical feed-through (158) at least in part comprises at least one vacuum valve (148), the vacuum valve (148) being designed to allow an evacuation of the cavity (146).

15. Method as claimed in the preceding claim, wherein a winding technique is used to generate the radiation shield (154), wherein the radiation shield (154) is wound onto the inner vessel (120).

## Revendications

1. Cryostat (116) destiné à être utilisé dans un système de mesure biomagnétique (110) et comprenant au moins un récipient intérieur (120) et au moins un récipient extérieur (140) ainsi qu'au moins une cavité (146) disposée entre le récipient intérieur (120) et le récipient extérieur (140),
une dépression pouvant être appliquée sur la cavité (146), au moins un écran pare-rayonnement (154) qui protège le cryostat (116) du rayonnement électromagnétique étant repris dans la cavité (146),
le cryostat (116) comportant en outre au moins un conducteur (156) de raccordement à la terre qui relie l'écran pare-rayonnement (154) à une masse électrique ou à la terre (160),
le conducteur (156) de raccordement à la terre étant relié dans la cavité (146) à l'écran pare-rayonnement (154),
le cryostat (116) présentant au moins un passage électrique (158) au moyen duquel le conducteur (156) de raccordement à la terre peut être mis en contact électrique à travers le récipient extérieur (140) depuis un côté extérieur du cryostat (116),
le passage électrique (158) comportant au moins une partie d'au moins une soupape de dépression (148), la soupape de dépression (148) étant destinée à permettre de mettre sous vide la cavité (146).

2. Cryostat (116) selon la revendication précédente, dans lequel la soupape sous vide (148) présente au moins un composant au moins en partie métallique, le composant métallique étant utilisé comme partie du conducteur (156) de raccordement à la terre.

3. Cryostat (116) selon la revendication précédente, dans lequel l'écran pare-rayonnement (154) comporte une structure stratifiée dotée d'au moins deux couches métalliques situées l'une au-dessus de l'autre, les couches métalliques étant reliées électriquement entre elles par une liaison ohmique et/ou par une liaison capacitive.

4. Cryostat (116) selon la revendication précédente, dans lequel l'écran pare-rayonnement (154) est conçu pour former un écran d'au moins 5 dB au rayonnement électromagnétique dans une plage de fréquence comprise entre 100 kHz et 1 GHz.

5. Cryostat (116) selon la revendication précédente, dans lequel l'écran pare-rayonnement (154) comporte au moins l'une des feuilles métalliques suivantes : une feuille d'aluminium, une feuille de cuivre, une feuille d'argent et une feuille d'or.

6. Cryostat (116) selon la revendication précédente, dans lequel l'écran pare-rayonnement (154) comporte au moins une feuille métallique d'une épaisseur comprise entre 5 micromètres et 500 micromètres, en particulier entre 10 micromètres et 100 micromètres et de façon particulièrement préférable d'une épaisseur de 70 micromètres.

7. Cryostat (116) selon l'une des deux revendications qui précèdent, dans lequel la feuille métallique comporte une feuille métallique auto-adhésive.

8. Cryostat (116) selon l'une des revendications qui précèdent, comprenant en outre au moins une couche super-isolante (152) disposée dans la cavité (146) pour faire écran au rayonnement thermique.

9. Cryostat (116) selon la revendication précédente, dans lequel la couche super-isolante (152) comporte au moins une feuille en matière synthétique et en particulier une feuille de polyéthylène.

10. Cryostat (116) selon l'une des deux revendications qui précèdent, dans lequel la couche super-isolante (152) comporte de plus au moins sur une face au moins un revêtement métallique.

11. Cryostat (116) selon l'une des trois revendications qui précèdent, dans lequel plusieurs couches super-isolantes (152) et plusieurs écrans pare-rayonnement (154) sont disposés en alternance dans la cavité (146).

12. Système de mesure biomagnétique (110) comportant au moins un cryostat (116) selon l'une des revendications précédentes et comportant en outre au moins un détecteur biomagnétique (112) destiné à détecter un champ magnétique.

13. Système de mesure biomagnétique (110) selon la revendication précédente, dans lequel le conducteur (156) de raccordement à la terre du cryostat (116) est relié à au moins une masse électrique ou à la terre (160).

14. Procédé de fabrication d'un cryostat (116) destiné à être utilisé dans un système de mesure biomagnétique (110), en particulier d'un cryostat (116) selon l'une des revendications précédentes qui concernent un cryostat (116), et comportant les étapes suivantes :
- former au moins un récipient intérieur (120) du cryostat (116),
- former au moins un écran pare-rayonnement (154) qui protège le cryostat (116) du rayonnement électromagnétique, l'écran pare-rayonnement (154) entourant de préférence au moins une partie du récipient intérieur (120),
- former au moins un récipient extérieur (140) du cryostat (116) et le monter avec le récipient intérieur (120) de manière à former entre le récipient intérieur 120) et le cryostat (140) au moins une cavité (146) apte à être mise sous vide, l'écran pare-rayonnement (154) étant repris au moins en partie dans la cavité (146), le récipient extérieur (140) comportant au moins un passage électrique (158), l'écran pare-rayonnement (154) étant relié électriquement au passage (158) par l'intermédiaire d'au moins un conducteur (156) de raccordement à la terre, le passage électrique (158) comportant au moins en partie au moins une soupape de dépression (148), la soupape de dépression (148) étant destinée à permettre de placer la cavité (146) sous vide.
(

15. Procédé selon la revendication qui précède, dans lequel, pour former l'écran pare-rayonnement (154), on utilise une technique d'enroulement, l'écran pare-rayonnement (154) étant enroulé sur le récipient intérieur (120).
